(19) Europäisches Patentamt / European Patent Office / Office européen des brevets

(11) **EP 2 660 615 B1**

(12) **EUROPEAN PATENT SPECIFICATION**

(45) Date of publication and mention
of the grant of the patent:
**21.11.2018 Bulletin 2018/47**

(51) Int Cl.:
*G01R 31/36* (2006.01)     *B60L 11/18* (2006.01)
*H01M 10/48* (2006.01)     *H02J 7/00* (2006.01)
*B60L 8/00* (2006.01)     *B60L 3/00* (2006.01)
*H01M 10/46* (2006.01)

(21) Application number: **11852347.1**

(22) Date of filing: **27.12.2011**

(86) International application number:
**PCT/JP2011/080349**

(87) International publication number:
**WO 2012/091076 (05.07.2012 Gazette 2012/27)**

(54) **BATTERY DEGRADATION LEVEL DETECTION METHOD**

VERFAHREN ZUR ERKENNUNG EINES BATTERIEABBAU-LEVELS

PROCÉDÉ DE DÉTECTION DE NIVEAU DE DÉGRADATION DE BATTERIE

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **28.12.2010 JP 2010294054**

(43) Date of publication of application:
**06.11.2013 Bulletin 2013/45**

(73) Proprietor: **Sanyo Electric Co., Ltd.
Osaka 570-8677 (JP)**

(72) Inventor: **MAEDA, Reizo
Moriguchi-shi, Osaka 570-8677 (JP)**

(74) Representative: **Hertz, Oliver
v. Bezold & Partner
Patentanwälte - PartG mbB
Akademiestrasse 7
80799 München (DE)**

(56) References cited:
**EP-A1- 1 933 158**     **JP-A- 6 342 045**
**JP-A- 2004 022 183**     **JP-A- 2007 533 979**
**JP-A- 2008 039 526**     **US-A1- 2006 152 196**
**US-A1- 2010 001 693**

**Description**

**BACKGROUND OF THE INVENTION**

1. Field of the Invention

The present invention relates to a method of detecting battery degradation level, and in particular to a method of detecting degradation level optimally suited for a battery used in a power source apparatus that drives an electric-powered vehicle or a battery used in a solar cell power storage unit.

2. Description of the Related Art

A rechargeable battery degrades with charge-discharge cycle repetitions and the capacity to which it can be charged decreases. Since degradation increases due to over-charging and over-discharging, degradation can be reduced and battery lifetime extended by preventing over-charging and over-discharging, and by limiting charging and discharging operation in regions close to over-charging and over-discharging. Further, degradation can be restrained and lifetime extended by reducing the allowable current, lowering the charging voltage, or narrowing the operating temperature range as degradation proceeds. To avoid degradation due to over-charging, over-discharging, and operation in regions close to over-charging and over-discharging, a driving battery on-board a vehicle such as a hybrid vehicle (hybrid car, hybrid electric vehicle, HEV) operates within a specified range of residual capacity (state-of-charge or SOC [%]) to reduce degradation and increase lifetime. For example, battery charging and discharging can be controlled within an SOC range of 50%±20%. To control charging and discharging and keep the residual capacity (SOC [%]) within a specified range, it is necessary to detect the full-charge capacity. This is because residual capacity (SOC [%]) is represented by the ratio of the amount of charge (Ah) capable of being discharged to the full charge capacity (Ah). The full-charge capacity can be determined by integrating the discharge current when the battery is discharged from a fully-charged state to a completely discharged state. Or, the full-charge capacity can be determined by integrating the charging current required to fully-charge the battery from a completely discharged state. However, full-charge capacity determination by these methods requires the battery either to be charged from a fully discharged state to a fully-charged state or to be discharged from a fully-charged state to a completely discharged state. For a battery used in an operating environment that does not completely discharge or fully-charge the battery, full-charge capacity cannot be detected by simply integrating the discharge current or charging current. For example, in a hybrid vehicle application, the vehicle cannot be driven by the battery if it is completely discharged, and the battery cannot be charged by regenerative braking if it is fully-charged. Further, for a battery charged by solar cells, solar cell output depends on weather conditions and battery discharge depends on load requirements. Consequently, it can be difficult to operate in a fully-charged state or completely discharged state in a solar cell power storage application as well.

Since full-charge capacity cannot be determined by integrating current in applications that limit battery degradation by controlling charging and discharging within a given residual capacity (SOC [%]) range, an alternate method of determining full-charge capacity is required. Charging and discharging cannot be controlled within a specified range of residual capacity (SOC [%]) if the full-charge capacity is not accurately detected. Consequently, accurate detection of the full-charge capacity is necessary for this type of limited charge-capacity-range operation. Since batteries have the property that full-charge capacity changes as battery degradation proceeds, full-charge capacity can be detected by accurately detecting the degree of battery degradation. Accordingly, accurate determination of the level of battery degradation is particularly important for a battery that has its charging and discharging controlled within a given residual capacity range. The level of battery degradation is set to 100% when output power is equal to the battery output power specification, and is set to 0% when output power becomes equal to the minimum output power.

Battery degradation can be limited and lifetime can be extended by reducing the allowable current, lowering the voltage allowed for charging, and narrowing the allowable temperature range for charging and discharging as battery degradation proceeds (as battery stress accumulates). Consequently, for a high capacity battery such as a driving battery carried on-board a vehicle or a battery used to store solar cell power, how accurately the accumulated battery stress, which is the degradation level, can be detected is extremely important for increasing battery lifetime to the maximum.

A method of detecting battery degradation level from charging current, discharging current, and temperature has been developed.

EP 1 933 158 A1 discloses a method for detecting SOC and SOH of a storage battery. The method includes calculating an SOC value of the storage battery with use of an SOC calculation unit based on a measured voltage value or a measured current value of the storage battery and calculating an SOH value of the storage battery with use of an SOH calculation unit based on the SOC value. The method includes further calculating a new SOC value with use of the SOC calculation unit based on the SOH value and calculating a new SOH value with use of the SOH calculation unit based on the new SOC value. These further calculations of SOC value and SOH value are repeated a prescribed n times of at least one so as to obtain an n-th calculated SOC value and an n-th calculated SOH value. The method includes outputting the n-th calculated SOH value as an SOH output value and outputting the n-th calculated SOH value as an SOC output value, and storing the SOH output value into a memory.

US 2010/001693 A1 provides a deterioration determination circuit. An SOC detection unit detects an SOC of a secondary battery. An internal resistance detection unit detects an internal resistance value of the secondary battery. A first determination unit determines the status of deterioration of the secondary battery based on the internal resistance value detected by the internal resistance detection unit when the SOC detected by the SOC detection unit is within a range of a pre-set first range. A second determination unit determines the status of deterioration of the secondary battery based on the internal resistance value detected by the internal resistance detection unit when the SOC detected by the SOC detection unit is within a range of a pre-set second range as a range of an SOC, in which a variation of the internal resistance of the second battery in relation to a variation of the SOC of the secondary battery is different from the first range. A final determination unit ultimately determines that the secondary battery is deteriorated when the first determination unit determines that the secondary battery is of the deteriorated status and the second determination unit additionally determines that the secondary battery is of the deteriorated status.

US 2006/152196 A1 discloses a method of controlling battery current limiting controls maximum charging and discharging current values according to the state of charge of the battery. The method of controlling current limiting integrates battery charging and discharging current to compute a first state of charge, determines first charging and discharging current limit value candidates from that first state of charge, computes a second state of charge based on battery voltage, and determines second charging and discharging current limit value candidates from that second state of charge. Further, the method takes the smaller of the first and second charging and discharging current limit value candidates as the charging and discharging current limit values for charging and discharging the battery.

Refer to Japanese Laid-Open Patent Publication 2008-122165.

SUMMARY OF THE INVENTION

ISSUES TO BE RESOLVED

Japanese Patent Publication JP 2008-122165 describes detection of the battery degradation level (state-of-health or SOH) from current and temperature according to the following equation:

$$\text{degradation level (SOH)} = \text{previously computed degradation level (SOH1)}$$
$$- \alpha \text{ (coefficient determined by the current value)}$$
$$- \beta \text{ (coefficient determined by the temperature)}$$

The method cited above detects the degree of battery degradation by the size of the current and the temperature. However, battery degradation level is not determined by the size of the current alone, and even in a state where the same current flows, the degradation level can be different depending on current flow conditions. For example, in a state where a constant current flows continuously, and in a state where the same current flows for a short time period, the degree of battery degradation is different even though the size of the current is the same. Accordingly, a method that detects battery degradation level from the size of the current and its integral has the drawback that an accurate degradation level is cannot always detected.

The present invention was developed to resolve the drawback described above. Thus, it is a primary object of the present invention to provide a method of detecting battery degradation level that can more accurately detect the degradation level from the battery current.

SUMMARY OF THE INVENTION

The method of detecting battery degradation level of the present invention detects the change in residual capacity ($\Delta$SOC) for one charging period from the start of charging until charging is stopped of a battery (1) being charged or one discharging period from the start of discharge until discharge is stopped of a battery 1 being discharged; weighting factors that establish degradation level according to the value of $\Delta$SOC are pre-stored in memory; and based on the stored data, weighting factors are determined from the detected $\Delta$SOC, and the battery 1 degradation level is detected from the weighting factors.

This method of detecting degradation level has the characteristic that degradation level can be detected more accurately. This is because the battery degradation level is detected from a change in the residual capacity ($\Delta$SOC) detected over one charging period or one discharging period, rather than simply from the current.

The method of detecting battery degradation level of the present invention can detect battery 1 temperature when current is flowing (conducting temperature) and when current is not flowing (storage temperature); weighting factors corresponding to conducting temperature and storage temperature can be pre-stored in memory; and based on the stored data, the battery 1 degradation level can be detected from a weighting factor determined from the detected storage temperature and from a weighting factor determined from the detected conducting temperature. Since this method detects battery degradation level from the storage temperature and the conducting temperature, it can accurately detect the degradation level in both an idle state and in a conducting state.

The method of detecting battery degradation level of the present invention can detect battery 1 current and temperature during current flow (conducting temperature); weighting factors corresponding to current and conducting temperature can be pre-stored in memory; based on the stored data, weighting factors can be determined from the detected current and conducting temperature, and the battery 1 degradation level can be detected from the determined weighting factors. Since this method detects battery degradation level from both the current and the conducting temperature, it can more accurately detect the degradation level in a conducting state.

In the method of detecting battery degradation level of the present invention, the allowable battery 1 current limit can be stored in memory, and the accumulated time that the current limit is exceeded can be detected to detect the battery 1 degradation level. Since this method detects degradation level not only from ΔSOC, but rather from both ΔSOC and the accumulated time exceeding the current limit, it can detect the degradation level more accurately.

In the method of detecting battery degradation level of the present invention, upper and lower battery 1 voltage limits can be stored in memory, and the accumulated time that the upper and lower voltage limits are exceeded can be detected to detect the battery 1 degradation level. Since this method detects degradation level considering the accumulated time exceeding the upper and lower voltage limits in addition to ΔSOC, it can detect the degradation level more accurately.

In the method of detecting battery degradation level of the present invention, the accumulated time in each battery storage temperature range can be recorded in memory, and battery degradation level can be detected based on the stored data.

In the method of detecting battery degradation level of the present invention, the accumulated time in each battery conducting temperature range can be recorded in memory, and battery degradation level can be detected based on the stored data.

In the method of detecting battery degradation level of the present invention, the accumulated time in each battery ΔSOC range can be recorded in memory, and battery degradation level can be detected based on the stored data.

The method of detecting battery degradation level of the present invention can be used in an application that controls battery 1 charging and discharging within a pre-set residual capacity (SOC [%]) range. In this method of detecting degradation level, full-charge capacity is accurately detected from the battery degradation level, and with the detected full-charge capacity, battery operation can be controlled within a fixed residual capacity range. As a result, this method has the characteristic that battery over-charging and over-discharging can be reliably prevented allowing extended lifetime.

The method of detecting battery degradation level of the present invention can be applied to a battery 1 that supplies power to a motor 12 to drive a vehicle. In this method of detecting degradation level, full-charge capacity of a battery that supplies power to a motor is detected from the degradation level, and from the detected full-charge capacity, over-charging and over-discharging can be prevented to minimize degradation. Accordingly, this method has the characteristic that the lifetime of a high-cost battery can be extended.

The method of detecting battery degradation level of the present invention can be applied to a battery 1 used in a power source that stores solar cell 20 power. In this method of detecting degradation level, full-charge capacity of a battery charged by solar cells is accurately detected from the degradation level, and from the detected full-charge capacity, over-charging and over-discharging can be prevented to minimize degradation. Accordingly, this method has the characteristic that the lifetime of a high-cost battery can be extended. The above and further objects of the present invention as well as the features thereof will become more apparent from the following detailed description to be made in conjunction with the accompanying drawings.

## BRIEF DESCRIPTION OF THE DRAWINGS

Fig. 1 is a block diagram showing an electric-powered vehicle power source apparatus used in the method of detecting battery degradation level for an embodiment of the present invention;
Fig. 2 is a block diagram showing a solar cell charged power source apparatus used in the method of detecting battery degradation level for an embodiment of the present invention;
Fig. 3 is a graph showing ΔSOC during charging and discharging of a battery installed on-board a vehicle;

Fig. 4 is a graph showing an example of root-mean-squared current ($I_{rms}$) computation from a plurality of detected current values;

Fig. 5 is a graph showing another example of root-mean-squared current ($I_{rms}$) computation from a plurality of detected current values;

Fig. 6 is a graph showing the first weighting factor and the second weighting factor;

Fig. 7 is a circuit diagram showing an equivalent circuit of a battery with internal resistance;

Fig. 8 is a graph showing battery current-voltage characteristics during charging and discharging;

Fig. 9 is a graph showing degradation level (SOH2) as a function of internal battery resistance; and

Fig. 10 is a flowchart of decision circuit computation of the degradation level (SOH).

## DETAILED DESCRIPTION OF THE EMBODIMENTS

The following describes embodiments of the present invention based on the figures. However, the following embodiments are merely specific examples of a method of detecting battery degradation level representative of the technology associated with the present invention, and the method of detecting battery degradation level of the present invention is not limited to the embodiments described below. Further, components cited in the claims are in no way limited to the components indicated in the embodiments.

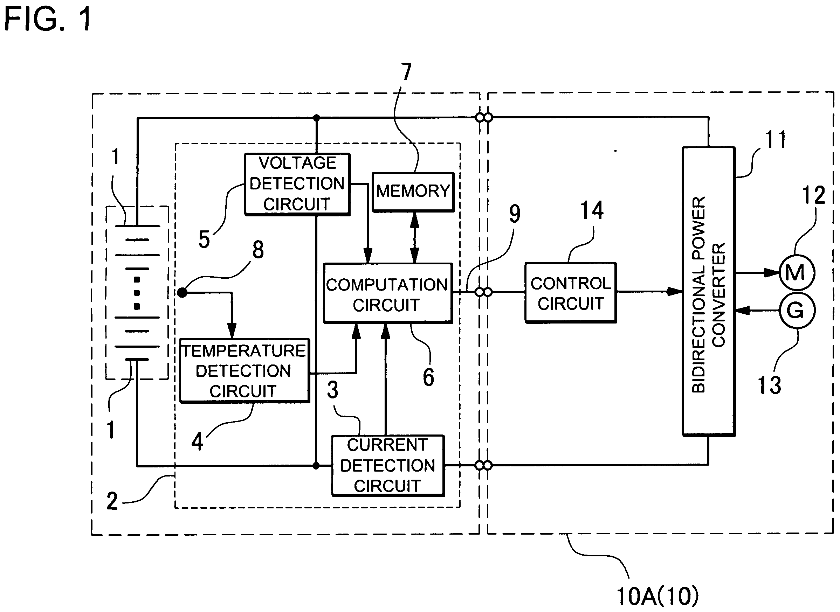

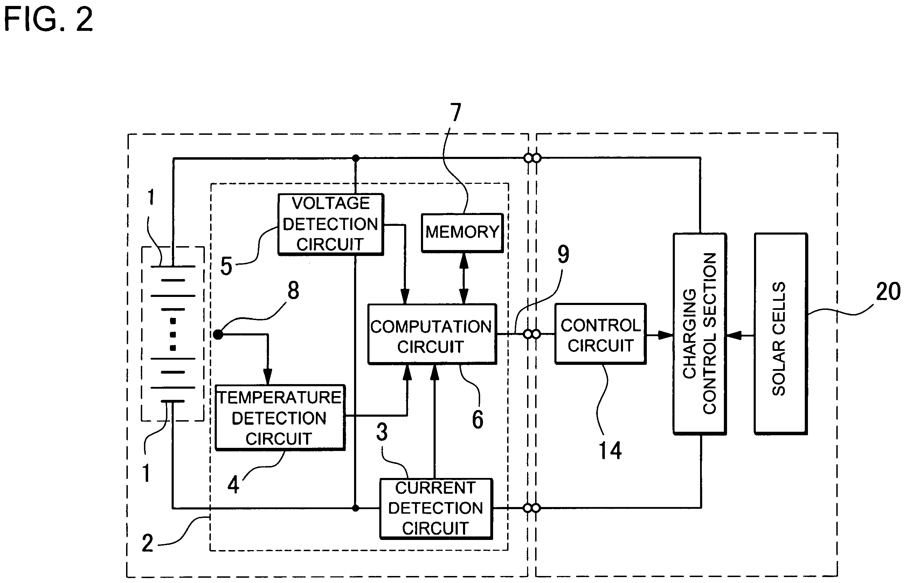

Figs. 1 and 2 are block diagrams of power source apparatus that use the method of detecting battery degradation level of the present invention. Fig. 1 shows a block diagram for determining the degradation level of a battery 1 installed on-board a hybrid vehicle 10A, and Fig. 2 shows a block diagram for determining the degradation level of a battery 1 charged by solar cells 20. However, the present invention is not limited to detecting degradation level of a battery applied in an electric-powered vehicle such as a hybrid vehicle, a plug-in hybrid electric vehicle, or electric vehicle (EV, electric automobile), or in a battery charged by solar cells. In a battery 1 used in an electric-powered vehicle such as a hybrid vehicle 10A or used with solar cells 20, full-charge capacity (Ah) is detected from the degradation level, and the residual capacity (SOC [%]) is computed from the ratio of the present battery capacity that can be discharged (Ah) to the detected full-charge capacity (Ah). This allows charging and discharging current to be controlled to keep the residual capacity (SOC [%]) within a specified range such as $50\%\pm20\%$.

The battery 1 in the hybrid vehicle 10A application of Fig. 1 is discharged by supplying power to the vehicle driving motor 12 and is charged by a generator 13 to maintain the residual capacity near the 50% level. The battery 1 degradation level (SOH) is detected by a decision circuit 2.

The vehicle-side is provided with a bidirectional power converter 11 that supplies power from the battery 1 to the motor 12 and supplies generator 13 power to the battery 1. The bidirectional power converter 11 converts battery 1 direct current (DC) power to three-phase alternating current (AC) power to supply to the motor 12, and converts generator 13 AC output to DC to supply to the battery 1. The bidirectional power converter 11 is controlled by a control circuit 14 that controls power supplied from the battery 1 to the motor 12 and charging power from the generator 13 to the battery 1. The control circuit 14 controls the bidirectional power converter 11 considering the battery 1 degradation level (SOH), which is sent via communication lines 9 from the decision circuit 2 on the power source apparatus-side. When the battery 1 degradation level (SOH) is in a normally anticipated range, the control circuit 14 controls the bidirectional power converter 11 according to a normal-mode. However, when the battery 1 degradation level (SOH) is lower than that expected under normal conditions, the control circuit 14 controls the bidirectional power converter 11 according to a restricted-mode, which reduces charging and discharging power compared to the normal-mode. Conversely, when the battery 1 degradation level (SOH) is larger than that expected under normal conditions, the control circuit 14 controls the bidirectional power converter 11 according to an accelerated-mode, which increases charging and discharging power compared to the normal-mode, or according to the normal-mode. With this type of control of motor 12 input and generator 13 output by the control circuit 14 using the bidirectional power converter 11, battery 1 lifetime can approach a targeted number of years of service.

To detect the battery 1 degradation level (SOH), the decision circuit 2 is provided with a current detection circuit 3 that detects charging and discharging current flow through the battery 1, a temperature detection circuit 4 that detects battery 1 temperature, a voltage detection circuit 5 that detects battery 1 voltage, and a computation circuit 6 that computes battery 1 degradation level (SOH) from the values detected by the various detection circuits.

In addition, the decision circuit 2 houses electrically erasable programmable read-only memory (EEPROM) as memory 7 circuitry. The degradation level (SOH) is stored in EEPROM and transmitted to the vehicle-side control circuit 14 via the communication lines 9.

The current detection circuit 3 and voltage detection circuit 5 are provided with analog-to-digital (A/D) converters (not illustrated) that convert detected analog current and voltage values to digital signals with a fixed sampling period. The current detection circuit 3 and voltage detection circuit 5 detect charging and discharging current and voltage values with a constant sampling period, convert the detected values to digital signals, and output those signals to the computation circuit 6. The current detection circuit 3 and voltage detection circuit 5 detect battery 1 current and voltage with a 100msec sampling period. However, the sampling period for current and voltage detection by the current detection circuit and voltage detection circuit is set to an optimal value according to the rate of change of the battery current and voltage. Specifically, the sampling period is set to an optimal value depending on whether current and voltage varies drastically over a short period or changes slowly over a long time, and for example, can be from 1msec to 1sec. Rapidly changing current and voltage can be detected more accurately by shortening the sampling period. However, a short sampling period requires faster A/D converter processing and increases the parts-cost. In addition, since a short sampling period means the decision circuit 6 must process current and voltage signals faster, decision circuit 6 parts-cost also increases. Conversely, if the sampling period is too long, time-varying current and voltage cannot be accurately detected. Accordingly, the sampling period for current and voltage detection is set to a time interval that can accurately detect the time-varying current and voltage.

The temperature detection circuit 4 converts analog temperature signals detected by a temperature sensor 8 to digital signals with a fixed sampling period. The temperature detection circuit 4 detects battery 1 temperature with a constant sampling period, converts the temperature values to digital signals, and outputs output those signals to the computation circuit 6. The temperature detection circuit 4 detects battery 1 temperature with a 1sec sampling period. However, the sampling period for temperature detection by the temperature detection circuit 4 is set to an optimal value according to the characteristic temperature variation. Specifically, the sampling period is set to an optimal value depending on whether the temperature varies radically over a short period or changes slowly over an extended time, and for example, can be from 10msec to 10sec. Rapidly changing temperature can be detected more accurately by shortening the sampling period.

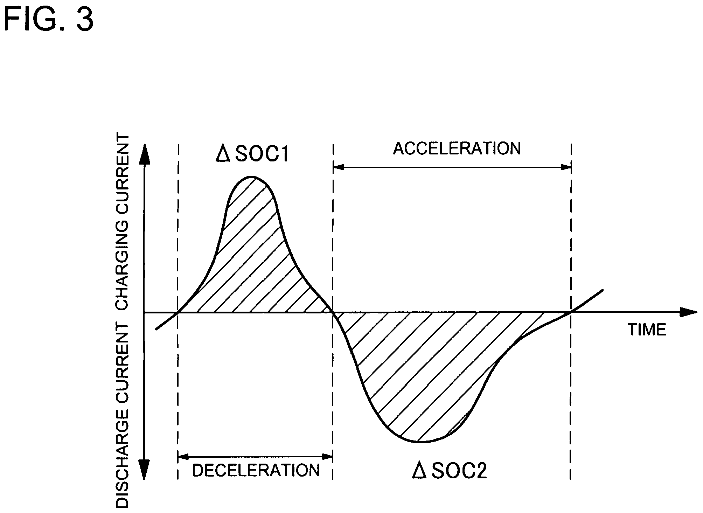

The decision circuit 2 detects the battery 1 degradation level (SOH) from the detected current, voltage, and temperature values. For degradation level (SOH) detection from current values, the computation circuit 6 detects a change in residual capacity ($\Delta$SOC) for one charging period and a change in residual capacity ($\Delta$SOC) for one discharging period from the current values. $\Delta$SOC for one discharging period is the amount of residual capacity change (%) from the start of discharge until discharge is stopped, and $\Delta$SOC for one charging period is the amount of residual capacity change (%) from the start of charging until charging is stopped. Fig. 3 is for a battery installed on-board a vehicle, and shows discharge during vehicle acceleration following charging due to regenerative braking. In this figure, the battery is charged to change the residual capacity from the start of regenerative braking until its completion, and the change in residual capacity is $\Delta$SOC1. Similarly, the battery is discharged and residual capacity changes from the time vehicle acceleration is initiated until the discharge is completed, and that change in residual capacity is $\Delta$SOC2.

Weighting factors W that establish battery 1 degradation level (SOH) corresponding to the change in residual capacity ($\Delta$SOC) are stored in memory as a look-up-table or function, and the computation circuit 6 detects battery 1 degradation level (SOH) from the weighting factor W stored for the particular $\Delta$SOC during charging or discharging. Battery 1 degradation level (SOH) increases as $\Delta$SOC increases. Accordingly, as shown in Table 1, the weighting factor W (%) increases with increasing $\Delta$SOC. The decision circuit 2 detects $\Delta$SOC for one battery 1 charging or discharging period, and with the detected $\Delta$SOC, determines a weighting factor W1-W8 (%) from the values stored in memory 7 to establish the degradation level (SOH). For example, a weighting factor W is determined from the values in Table 1 and the present battery degradation level (SOH) is determined from the following equation.

$$\text{Present degradation level (SOH [\%])} = \text{previous degradation level (SOH [\%])}$$

$$- \text{W (weighting factor corresponding to the } \Delta\text{SOC [\%])}$$

[Table 1]

| $\Delta$SOC (%) | Weighting Factor W (%) |
|---|---|
| $\Delta$SOC $\leq$ 0.1 | W1 = 0.09x10$^{-3}$ |
| 0.1 < $\Delta$SOC $\leq$ 0.2 | W2 = 0.28x10$^{-3}$ |
| 0.2 < $\Delta$SOC $\leq$ 0.5 | W3 = 0.68x10$^{-3}$ |
| 0.5 < $\Delta$SOC $\leq$ 1 | W4 = 1.56x10$^{-3}$ |
| 1 < $\Delta$SOC $\leq$ 2 | W5 = 3.45x10$^{-3}$ |
| 2 < $\Delta$SOC $\leq$ 5 | W6 = 10.16x10$^{-3}$ |
| 5 < $\Delta$SOC $\leq$ 10 | W7 = 30.79x10$^{-3}$ |

(continued)

| ΔSOC (%) | Weighting Factor W (%) |
|---|---|
| 10 < ΔSOC | W8 = 95.43x10^{-3} |

For example, if ΔSOC for one charging or discharging period is 1%, the weighting factor W for determining the degradation level (SOH [%]) is $1.56 \times 10^{-3}$%. Accordingly, from the equation above, for each battery 1 charging or discharging period that changes the state of charge such that ΔSOC is 1%, the battery 1 degradation level (SOH) decreases by $1.56 \times 10^{-3}$%.

Weighting factors W that establish the degradation level (SOH) from ΔSOC are different for different types of batteries 1. Accordingly, for the weighting factors W described above, a battery 1 is actually charged and discharged measuring ΔSOC for one charging period or one discharging period, the weighting factors W to establish degradation level (SOH) are measured for one ΔSOC period, and the results are stored in memory 7.

Next, for a decision circuit 2 that detects degradation level (SOH) according to the current, degradation is detected from an effective (root-mean-squared) value of the current ($I_{rms}$), and the degradation level (SOH) is determined from both ΔSOC and the root-mean-squared current ($I_{rms}$). The computation circuit 6 in the decision circuit 2 determines root-mean-squared current ($I_{rms}$) from digital current value signals input from the current detection circuit 3. The computation circuit 6 computes root-mean-squared current to detect an effective current ($I_{rms}$) according to the following equation.

$$\text{Effective current } (I_{rms}) = [(i_1^2 + i_2^2 + i_3^2 + \cdots + i_n^2) / n]^{1/2}$$

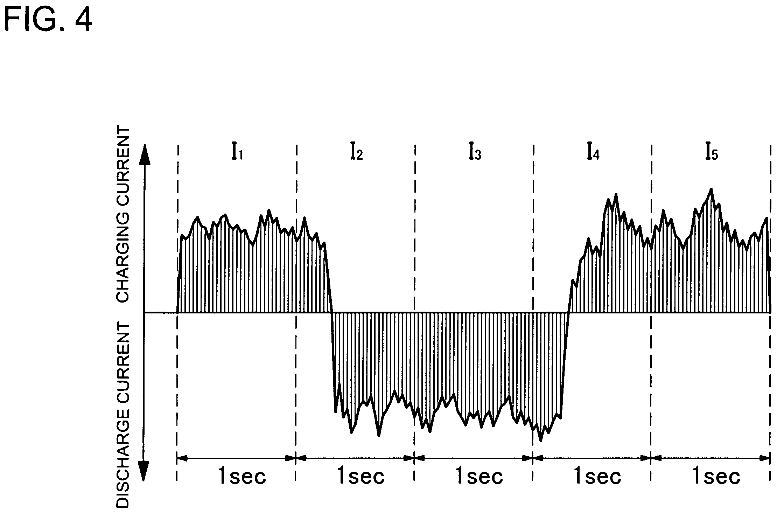

The effective current ($I_{rms}$) is computed from a plurality of sequentially detected current values. For example, as shown in Fig. 4, current values are detected with a 10msec sampling period, and effective currents are computed for each 1sec interval ($I_1$, $I_2$, $I_3$, $I_4$, $I_5$, ····). Battery degradation level is determined for each effective current ($I_{rms}$) computed from detected current. The computation circuit 6 has a look-up-table or function stored in memory 7 that identifies weighting factors W corresponding to effective current ($I_{rms}$) to establish the degradation level. A decision circuit 3 that detects effective current ($I_{rms}$) with a 1sec periodicity stores weighting factors W that establish the amount of battery 1 degradation for each second of operation based on the effective current ($I_{rms}$) that flows in each 1sec interval. The computation circuit 6 detects degradation level from weighting factors stored in memory 7 corresponding to effective current ($I_{rms}$) to determine the present battery 1 degradation level (SOH).

The computation circuit 6 can also determine degradation level from a cumulative effective current ($I_{rms}$) rather than determining battery 1 degradation level for each periodically detected effective current ($I_{rms}$). For example, a 1min cumulative effective current value (charge) can be detected from the product of effective current ($I_{rms}$) and time, and the degradation level can be determined from that cumulative product. The computation circuit 6 has a look-up-table or function stored in memory 7 that identifies weighting factors W that establish the battery 1 degradation level corresponding to the cumulative effective current. This computation circuit 6 detects the battery 1 degradation level from weighting factors W stored corresponding to cumulative effective current.

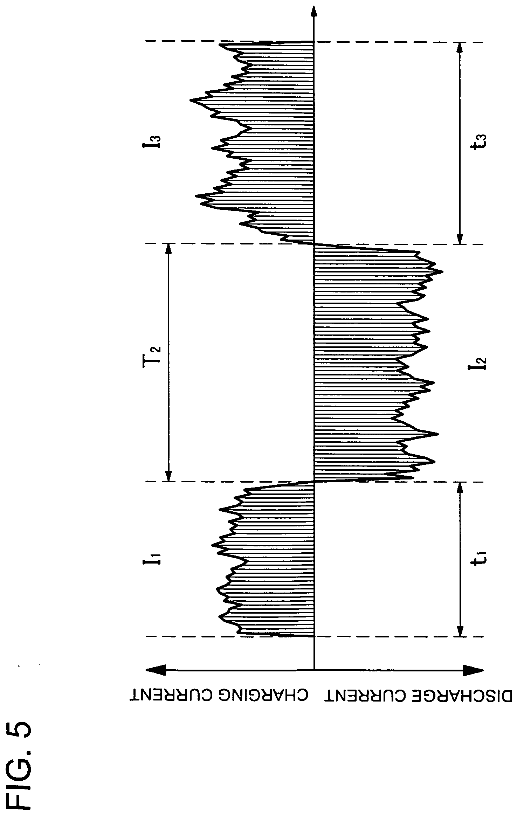

The computation circuit 6 can also align the cumulative effective current ($I_{rms}$) time intervals with periods of charging and discharging, and the degradation level can be determined from those cumulative effective currents. For example, as shown in Fig. 5, the computation circuit 6 multiplies effective currents ($I_{rms}$) times the respective time intervals for a discharging period ($T_2$) and charging periods ($t_1$, $t_2$) to determines battery 1 degradation level from those cumulative products. The computation circuit 6 has weighting factors W, which establish the degradation level, stored in memory 7 corresponding to cumulative effective discharge current ($I_{rms}$) and cumulative effective charging current ($I_{rms}$). This computation circuit 6 detects battery 1 degradation level from weighting factors W stored corresponding to cumulative effective current. Weighting factors W that establish battery 1 degradation level corresponding to cumulative effective discharge current ($I_{rms}$) and cumulative effective charging current ($I_{rms}$) are detected by actually charging or discharging the battery 1 with a given effective current ($I_{rms}$), and are stored in memory 7.

The computation circuit 6 can also average digital signal values detected by the current detection circuit 3 to detect average current, and compute effective current ($I_{rms}$) from the average current values. For example, the computation circuit 6 adds and averages a plurality of current values and computes effective current ($I_{rms}$) from the computed average current values. Further, the computation circuit 6 can compute average current values from a plurality of detected current values discarding the maximum and minimum values, and compute effective current ($I_{rms}$) from those amended average current values. This computation circuit 6 can detect battery 1 current accurately be discarding values that cannot be accurately detected due to conditions such as noise.

The decision circuit 2 can also determine battery 1 degradation level from the accumulated time that battery 1 charging or discharging effective current ($I_{rms}$) exceeds a preset current limit. This decision circuit 2 has weighting factors W, which establish the degradation level, stored in memory 7 corresponding to the accumulated time exceeding the current limit. The decision circuit 2 determines the battery 1 degradation level from weighting factors W corresponding to the accumulated times stored in memory 7. For this decision circuit 2, current exceeding the preset current limit is made to flow through the battery 1, weighting factors W that establish the battery 1 degradation level from the accumulated time are determined, and weighting factors W corresponding to accumulated times are stored in memory 7. This decision circuit 2 can more accurately detect the battery 1 degradation level (SOH) by adding the degradation level due to charging and discharging ΔSOC, the degradation level due to effective battery 1 charging and discharging current ($I_{rms}$), and the degradation level due to battery 1 current exceeding the preset current limit.

The decision circuit 2 can also determine battery 1 degradation level from the root-mean-square of the charging and discharging current and from the accumulated time that preset upper and lower voltage limits are exceeded. This decision circuit 2 has weighting factors W, which establish the degradation level, stored in memory 7 corresponding to the accumulated time exceeding the upper and lower voltage limits. Weighting factors W corresponding to accumulated time exceeding the upper and lower battery 1 voltage limits are measured under conditions actually exceeding the upper and lower voltage limits, and those weighting factors W are stored in memory 7. Battery 1 degradation level is determined from the weighting factors W stored in memory 7 corresponding to the accumulated time exceeding the voltage limits. This decision circuit 2 can accurately detect the total battery 1 degradation level (SOH) by adding the degradation level detected from ΔSOC, the degradation level detected from effective battery 1 charging and discharging current ($I_{rms}$), the degradation level detected from the accumulated time that battery 1 current exceeds the current limit, and the degradation level detected from the accumulated time that battery 1 voltage exceeds the upper and lower voltage limits.

Next, the decision circuit 2 can detect the degree of degradation due to battery 1 temperature to determine the degradation level (SOH) considering temperature-related deterioration as well. A decision circuit 2, which determines degradation level (SOH) due to temperature, detects battery 1 storage temperature and conducting temperature. Weighting factors W, which establish the degradation level, are pre-stored in memory 7 corresponding to storage temperature and conducting temperature. The decision circuit 2 uses the stored data to determine battery 1 degradation level from weighting factors W corresponding to the detected storage and conducting temperatures.

Table 2 illustrates an example of weighting factors W10-W17 corresponding to storage temperature, and Table 3 illustrates an example of weighting factors W20-W27 corresponding to conducting temperature.

[Table 2]

| Storage temperature T (°C) | Weighting Factor W (%) |
|---|---|
| T ≤ -10 | W10 = $0.02 \times 10^{-7}$ |
| -10 < T ≤ 10 | W11 = $0.06 \times 10^{-7}$ |
| 10 < T ≤ 25 | W12 = $0.46 \times 10^{-7}$ |
| 25 < T ≤ 35 | W13 = $1.64 \times 10^{-7}$ |
| 35 < T ≤ 45 | W14 = $4.20 \times 10^{-7}$ |
| 45 < T ≤ 55 | W15 = $10.14 \times 10^{-7}$ |
| 55 < T ≤ 60 | W16 = $18.96 \times 10^{-7}$ |
| 60 < T | W17 = $23.22 \times 10^{-7}$ |

[Table 3]

| Conducting temperature T (°C) | Weighting Factor W (%) |
|---|---|
| T ≤ -10 | W20 = $0.02 \times 10^{-7}$ |
| -10 < T ≤ 10 | W21 = $0.07 \times 10^{-7}$ |
| 10 < T ≤ 25 | W22 = $0.51 \times 10^{-7}$ |
| 25 < T ≤ 35 | W23 = $1.80 \times 10^{-7}$ |
| 35 < T ≤ 45 | W24 = $5.04 \times 10^{-7}$ |
| 45 < T ≤ 55 | W25 = $12.17 \times 10^{-7}$ |

(continued)

| Conducting temperature T (°C) | Weighting Factor W (%) |
|---|---|
| 55 < T ≤ 60 | $W26 = 24.64 \times 10^{-7}$ |
| 60 < T | $W27 = 30.19 \times 10^{-7}$ |

Battery 1 degradation level increases as the storage temperature and conducting temperature increase. Accordingly, as shown in the examples of Tables 2 and 3, weighting factors W (%) are set corresponding to storage temperature and conducting temperature to increase as temperature increases. The decision circuit 2 detects battery 1 storage temperature and conducting temperature during charging and discharging, and detects a weighting factor W10-W17 (%) to establish degradation level with the detected storage temperature and a weighting factor W20-W27 (%) to establish degradation level with the detected conducting temperature from the values stored in memory 7. For example, the decision circuit 2 detects the actual battery 1 degradation level (SOH) by determining weighting factors W from the values in Tables 2 and 3.

Weighting factors W that establish degradation level according to storage temperature and conducting temperature are different for different types of batteries 1. Accordingly, the battery 1 is actually stored or operated at specific temperatures, weighting factor values corresponding to temperature are measured, and those values are stored in memory 7.

Next, the decision circuit 2 can detect the degree of degradation (SOH) by measuring internal battery 1 resistance. A decision circuit 2 that detects battery 1 degradation level (SOH) from internal resistance determines both a first degradation level (SOH1) from detected values other than internal resistance and a second degradation level (SOH2) from the internal resistance. This decision circuit 2 does not simply add the first degradation level (SOH1) and the second degradation level (SOH2) to determine the degradation level (SOH), but rather determines total degradation level (SOH) from a weighted sum of the first degradation level (SOH1) and second degradation level (SOH2) according to the following equation:

$$\text{Degradation level (SOH)} = \text{first weighting factor} \times \text{SOH1} + \text{second weighting factor} \times \text{SOH2}$$

where the sum of the first and second weighting factors is one.

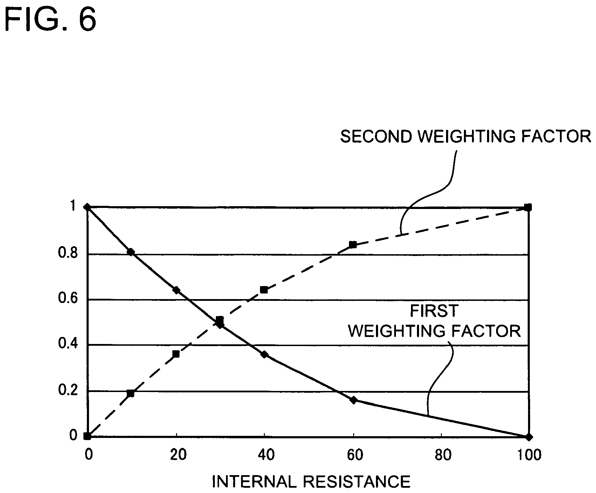

As shown by the graph in Fig. 6, the first weighting factor and second weighting factor are set according to the internal resistance. In this figure, the horizontal axis represents a relative value corresponding to the internal battery 1 resistance and the vertical axis indicates the first weighting factor and second weighting factor. In this figure, when the battery 1 degradation level (SOH) is 0%, which is when the battery 1 has reached the end of its lifetime, the relative internal resistance is set to 100. As shown in this figure, as battery 1 degradation proceeds and the degradation level (SOH) decreases (increased degradation), the first weighting factor decreases and the second weighting factor increases. This is because as internal resistance increases to put the battery 1 in a deteriorated state, the internal resistance accurately determines the degradation level (SOH). In this method, the first weighting factor and second weighting factor are set depending on the internal battery 1 resistance. However, the first weighting factor and second weighting factor can also be specified from the second degradation level (SOH2), which depends on internal battery 1 resistance, or from the total degradation level (SOH), which depends on the first degradation level (SOH1) and the second degradation level (SOH2). In that case, the first weighting factor is made small and the second weighting factor is made large as the second degradation level (SOH2) or the total degradation level (SOH) decreases, which is when battery 1 lifetime approaches its maximum value.

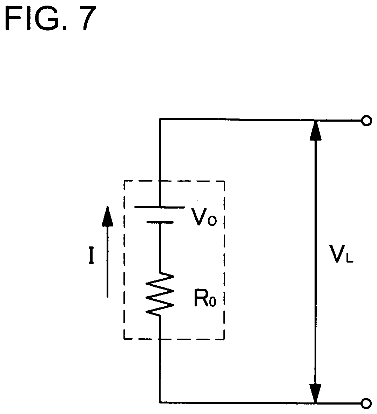

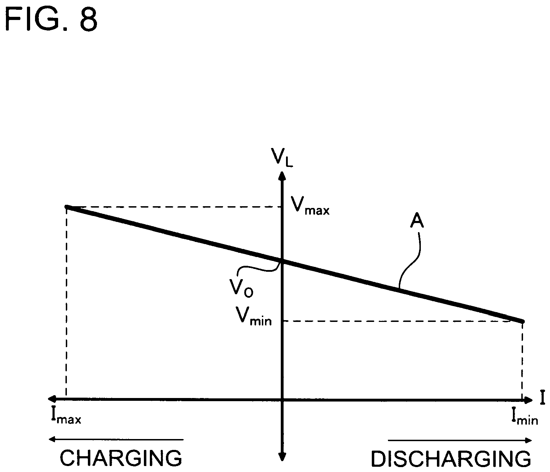

Internal battery 1 resistance is detected by the decision circuit 2. The decision circuit 2 detects internal battery 1 resistance and determines the second degradation level (SOH2) from the internal resistance. An equivalent circuit for a battery 1 with internal resistance is shown in Fig. 7. If the battery 1 in this equivalent circuit is charged and discharged, and the current I and output voltage VL are measured and plotted, a graph with the form of Fig. 8 results. In Fig. 8, the internal resistance R0 can be calculated from the slope of line A, which represents the battery 1 current-voltage characteristics. If the battery 1 open-circuit voltage is Vo and a voltage VL results when current I flows:

$$VL = Vo - R0 \times I$$

and rearranging that equation, internal resistance is computed as follows.

$$R0 = (Vo - VL) / I$$

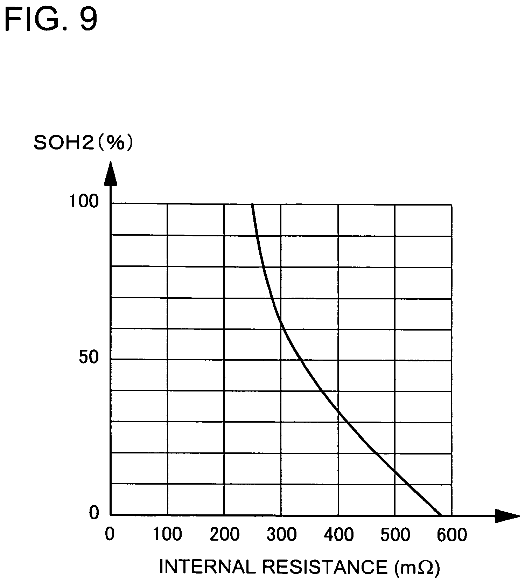

The second degradation level (SOH2) corresponding to internal battery 1 resistance is pre-stored as a look-up-table or as a function in the decision circuit 2. An example of second degradation level (SOH2) versus internal battery 1 resistance stored as a look-up-table or function is shown in graphical form in Fig. 9. A battery with the characteristics shown in this figure has a second degradation level (SOH2) of 60% when its internal resistance is 300mΩ.

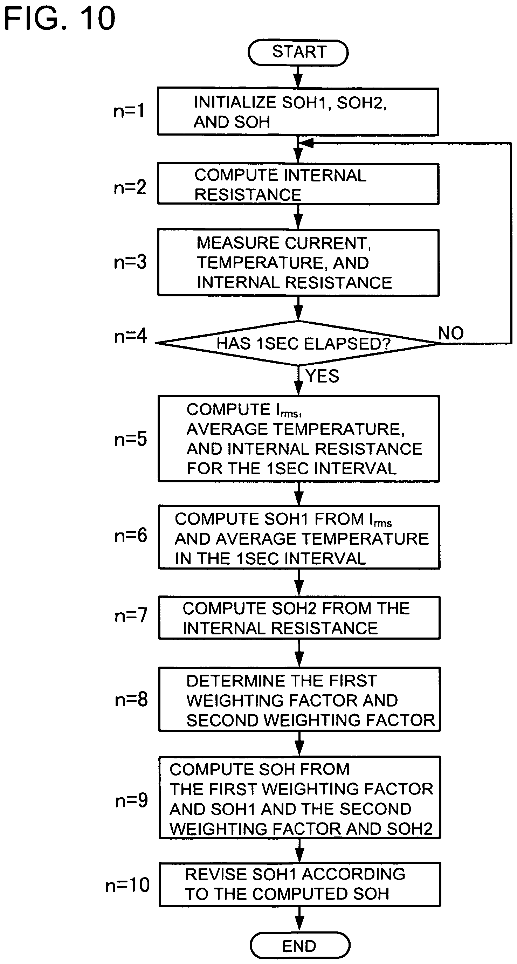

A decision circuit 2 that detects the battery 1 degradation level (SOH) from a first degradation level (SOH1) and a second degradation level (SOH2) determines a first weighting factor and second weighting factor from the detected first degradation level (SOH1) and second degradation level (SOH2). A flowchart for decision circuit 2 computation of the degradation level (SOH) is shown in Fig. 10 and described as follows.

[Step n=1]

The decision circuit 2 sets initial values for the first degradation level (SOH1), the second degradation level (SOH2), and the degradation level (SOH) from data stored in internal memory 7.

[Step n=2]

The decision circuit 2 computes internal resistance from battery 1 current and voltage. Here, measurement accuracy is improved by compensating for temperature. This is because internal resistance varies as a function of temperature. Battery 1 temperature is measured when the internal resistance is detected, and the detected (temperature dependent) internal resistance is converted to the internal resistance at a specified temperature. A decision circuit 2 that compensates internal resistance for temperature has internal resistance versus temperature stored in memory as a look-up-table or function. The internal resistance is corrected to internal resistance at a specified temperature according to the values stored in memory.

[Step n=3]

Battery 1 charging and discharging current, temperature, and internal resistance (compensated for temperature) are measured.

[Step n=4]

Control loops through steps n=2-4 until 1sec has elapsed.

[Step n=5]

When 1sec has elapsed, the effective current ($I_{rms}$), average temperature, and internal resistance are computed for that 1sec interval.

[Step n=6]

The decision circuit 2 uses the effective current ($I_{rms}$) and average temperature in the 1sec interval to determine the first degradation level (SOH1).

[Step n=7]

The decision circuit 2 determines the second degradation level (SOH2) from the internal resistance based on a look-up-table or function stored in memory.

[Step n=8]

The decision circuit 2 establishes the first weighting factor and second weighting factor for the first degradation level (SOH1) and second degradation level (SOH2). The first weighting factor and second weighting factor are established as shown in Fig. 6.

[Step n=9]

The decision circuit 2 computes overall battery 1 degradation level (SOH) from the first weighting factor and first degradation level (SOH1), and from the second weighting factor and second degradation level (SOH2).

[Step n=10]

Since the first degradation level (SOH1) approaches the overall degradation level (SOH) as degradation proceeds, the first degradation level (SOH1) is revised based on the computed degradation level (SOH).

In this manner, the decision circuit 2 determines the battery 1 degradation level (SOH) and sends the resulting (SOH) values to a control circuit on the vehicle-side or solar cell-side via the communication lines 9.

By detecting the degradation level (SOH) in the manner described above, it is possible to know the battery 1 lifetime. Further, by pre-storing various characteristics (such as the relation of voltage, residual capacity, and full-charge capacity to the degradation level) for each degradation level (SOH), those stored characteristics can be used as required at the point in time when the degradation level (SOH) is determined.

The decision circuit 2 has a look-up-table or function stored in memory that indicates full-charge capacity (Ah) corresponding to the battery 1 degradation level (SOH). If full-charge capacity (Ah) is determined from the degradation level (SOH) for a battery 1 charged and discharged in a vehicle or solar cell application, residual capacity (SOC [%]) can be computed from the ratio of battery capacity that can be discharged (Ah) to the full-charge capacity (Ah). The battery capacity that can be discharged (Ah) is computed by integrating battery 1 charging and discharging current. Here, the capacity that can be discharged (Ah) is computed by subtracting the integrated value of discharge current from the integrated value of charging current. If the residual capacity (SOC [%]) is determined, charging and discharging current can be controlled to keep the residual capacity (SOC [%]) within a given range. For example, charging and discharging current can be controlled to keep the residual capacity (SOC [%]) within a range of 30% to 70%, 20% to 80%, or 10% to 90% to reduce degradation and extend battery 1 lifetime.

Further, if battery 1 degradation level (SOH) is determined, charging and discharging can be conducted while protecting the battery 1 according to its degradation level (SOH) by limiting the maximum current flow in the battery 1 or reducing the maximum voltage during charging.

For a battery 1 installed on-board a vehicle, when the ignition switch is in the ON state, which is when the vehicle is being operated, the decision circuit 2 detects parameters such as $\Delta$SOC, effective current ($I_{rms}$), battery 1 temperature, accumulated time exceeding the allowable current, and accumulated time exceeding the upper and lower voltage limits in each given time interval during charging and discharging to determine battery 1 degradation level (SOH).

For a battery 1 charged by solar cells 20, battery 1 degradation level (SOH) is determined with a constant period such as from 1sec to 1min.

As described above, battery 1 degradation level (SOH) increases as $\Delta$SOC increases, and the actual battery 1 degradation level (SOH) can be determined, for example, from the weighting factors in Table 1. Degradation level (SOH) also increases as the battery 1 storage and conducting temperature increase, and the actual battery 1 degradation level (SOH) can be determined for example, from the weighting factors in Tables 2 and 3. Meanwhile, the cumulative number of times each $\Delta$SOC interval in Table 1 is accessed, and the accumulated time in each temperature range shown in Tables 2 and 3 can be stored in memory 7. At maintenance or service time, stored data can be readout to establish battery 1 degradation level based on investigation of whether or not operation has exceeded given conditions.

Further, depending on investigation of whether or not operation has exceeded given conditions, the stored data can be used to determine whether battery/power source apparatus replacement is at the user's expense or free-of-charge.

The method of detecting battery degradation level of the present invention can be appropriately used in a power source apparatus in a vehicle such as a plug-in hybrid electric vehicle that can switch between an electric vehicle (EV) mode and a hybrid electric vehicle (HEV) mode, a hybrid (electric) vehicle, and an electric vehicle. The present invention can also be appropriately used in applications such as a server computer backup power source that can be rack-installed, a backup power source apparatus for a wireless base station such as a mobile phone base station, a power storage apparatus for the home or manufacturing facility, a streetlight power source, a power storage apparatus for use with solar cells, and a backup power source in systems such as traffic signals.

## Claims

**1.** A method of detecting battery degradation level, comprising:

detecting a ∆SOC being a residual capacity change for one charging period from the start of charging until charging is stopped of a battery (1) being charged or one discharging period from the start of discharge until discharge is stopped of the battery (1) being discharged;

determining weighting factors that establish degradation level according to the value of ∆SOC, the weighting factors being pre-stored in memory (7); and

detecting the battery degradation level from the weighting factors.

2. The method of detecting battery degradation level as cited in claim 1 wherein battery storage temperature and conducting temperature when current is flowing are measured, weighting factors corresponding to storage temperature and conducting temperature when current is flowing are pre-stored in memory (7), and based on the stored data, the battery degradation level is detected from weighting factors determined from the detected storage temperature and from weighting factors determined from the detected conducting temperature when current is flowing.

3. The method of detecting battery degradation level as cited in claim 1 or 2 wherein battery current and conducting temperature when current is flowing are measured, weighting factors corresponding to current and conducting temperature when current is flowing are pre-stored in memory (7), based on the stored data, weighting factors are determined from the detected current and conducting temperature when current is flowing, and the battery degradation level is detected from the determined weighting factors.

4. The method of detecting battery degradation level as cited in any one of the claims 1-3 wherein the allowable battery current limit is stored in memory (7), and the accumulated time that the current limit is exceeded is detected to determine the battery degradation level.

5. The method of detecting battery degradation level as cited in any one of the claims 1-4 wherein upper and lower battery voltage limits are stored in memory (7), and the accumulated time that the upper and lower voltage limits are exceeded are detected to determine the battery degradation level.

6. The method of detecting battery degradation level as cited in any one of the claims 1-5 wherein the accumulated time in each battery storage temperature range is recorded in memory (7) and battery degradation level is detected based on the stored data.

7. The method of detecting battery degradation level as cited in any one of the claims 1-6 wherein the accumulated time in each battery conducting temperature range when current is flowing is recorded in memory (7), and battery degradation level is detected based on the stored data.

8. The method of detecting battery degradation level as cited in any one of the claims 1-7 wherein the accumulated time in each ∆SOC range is recorded in memory (7), and battery degradation level is detected based on the stored data.

9. The method of detecting battery degradation level as cited in any one of the claims 1-8 used in an application that controls battery charging and discharging within a pre-set residual capacity range.

10. The method of detecting battery degradation level as cited in claim 9 used in a battery (1) that supplies power to a motor to drive a vehicle (10).

11. The method of detecting battery degradation level as cited in claim 9 applied to a battery (1) used in a power source that stores solar cell power.

**Patentansprüche**

1. Verfahren zur Erkennung eines Batterieabbau-Levels, umfassend:

Detektion eines ∆SOC, das eine Restkapazitätsänderung für eine Ladeperiode vom Beginn des Ladens bis zum Ende des Ladens einer Batterie (1), die geladen wird, oder eine Entladeperiode vom Beginn des Entladens bis zum Ende des Entladens der Batterie (1) ist, die entladen wird;

Bestimmung von Gewichtungsfaktoren, die den Abbaulevel gemäß dem Wert von ∆SOC festlegen, wobei die Gewichtungsfaktoren in einem Speicher (7) vorab gespeichert sind; und

Erkennung des Batterieabbau-Levels aus den Gewichtungsfaktoren.

2. Verfahren zur Erkennung des Batterieabbau-Levels gemäß Anspruch 1, bei dem eine Batteriespeichertemperatur und eine Leitungstemperatur, wenn Strom fließt, gemessen werden, wobei Gewichtungsfaktoren, die der Speichertemperatur und der Leitungstemperatur, wenn Strom fließt, entsprechen, im Speicher (7) vorab gespeichert werden und auf der Grundlage der gespeicherten Daten der Batterieabbau-Level aus Gewichtungsfaktoren, die aus der detektierten Speichertemperatur ermittelt sind, und aus Gewichtungsfaktoren erkannt wird, die aus der detektierten Leitungstemperatur, wenn Strom fließt, ermittelt sind.

3. Verfahren zur Erkennung des Batterieabbau-Levels gemäß Anspruch 1 oder 2, wobei ein Batteriestrom und eine Leitungstemperatur, wenn Strom fließt, gemessen werden, Gewichtungsfaktoren entsprechend dem Strom und der Leitungstemperatur, wenn Strom fließt, im Speicher (7) vorab gespeichert werden, auf der Grundlage der gespeicherten Daten Gewichtungsfaktoren aus dem erfassten Strom und der Leitungstemperatur, wenn Strom fließt, bestimmt werden, und der Batterieabbau-Level aus den ermittelten Gewichtungsfaktoren ermittelt wird.

4. Verfahren zur Erkennung des Batterieabbau-Levels gemäß einem der Ansprüche 1 - 3, wobei die zulässige Batteriestromgrenze im Speicher (7) gespeichert wird und die akkumulierte Zeit, in der die Stromgrenze überschritten wird, zur Bestimmung des Batterieabbau-Levels detektiert wird.

5. Verfahren zur Erkennung des Batterieabbau-Levels gemäß einem der Ansprüche 1 - 4, wobei obere und untere Batteriespannungsgrenzen im Speicher (7) gespeichert werden und die akkumulierte Zeit, in der die oberen und unteren Spannungsgrenzen überschritten werden, zur Bestimmung des Batterieabbau-Levels detektiert wird.

6. Verfahren zur Erkennung des Batterieabbau-Levels gemäß einem der Ansprüche 1 - 5, wobei die akkumulierte Zeit in jedem Batteriespeichertemperaturbereich im Speicher (7) aufgezeichnet wird und der Batterieabbau-Level auf der Grundlage der gespeicherten Daten erkannt wird.

7. Verfahren zur Erkennung des Batterieabbau-Levels gemäß einem der Ansprüche 1 - 6, wobei die akkumulierte Zeit in jedem Leitungstemperaturbereich der Batterie, wenn Strom fließt, im Speicher (7) aufgezeichnet wird und der Batterieabbau-Level auf der Grundlage der gespeicherten Daten erkannt wird.

8. Verfahren zur Erkennung des Batterieabbau-Levels gemäß einem der Ansprüche 1 - 7, wobei die akkumulierte Zeit in jedem $\Delta$SOC-Bereich im Speicher (7) aufgezeichnet wird und der Batterieabbau-Level auf der Grundlage der gespeicherten Daten erkannt wird.

9. Verfahren zur Erkennung des Batterieabbau-Levels gemäß einem der Ansprüche 1 - 8, das in einer Anwendung verwendet wird, die das Laden und Entladen der Batterie innerhalb eines voreingestellten Restkapazitätsbereichs steuert.

10. Verfahren zur Erkennung des Batterieabbau-Levels gemäß Anspruch 9, das in einer Batterie (1) verwendet wird, die einen Motor zum Antrieb eines Fahrzeugs (10) mit Strom versorgt.

11. Verfahren zur Erkennung des Batterieabbau-Levels gemäß Anspruch 9, das bei einer Batterie (1) angewendet wird, die in einer Stromquelle verwendet wird, die Solarzellenenergie speichert.

**Revendications**

1. Procédé de détection de niveau de dégradation de batterie, comprenant :

   la détection d'un $\Delta$SOC étant un changement de capacité résiduelle pour une période de charge allant du début de la charge jusqu'à l'interruption de la charge d'une batterie (1) étant chargée ou une période de décharge allant du début de la décharge jusqu'à l'interruption de la décharge de la batterie (1) étant déchargée ;
   la détermination de facteurs de pondération qui établissent le niveau de dégradation en fonction de la valeur de $\Delta$SOC, les facteurs de pondération étant pré-stockés dans la mémoire (7) ; et
   la détection du niveau de dégradation de batterie à partir des facteurs de pondération.

2. Procédé de détection de niveau de dégradation de batterie selon la revendication 1, dans lequel la température de stockage et la température de conduction de la batterie lorsque le courant circule sont mesurées, des facteurs de pondération correspondant à la température de stockage et à la température de conduction lorsque le courant circule sont pré-stockés dans la mémoire (7), et en fonction des données stockées, le niveau de dégradation de batterie est détecté à partir de facteurs de pondération déterminés à partir de la température de stockage détectée et à partir de facteurs de pondération déterminés à partir de la température de conduction détectée lorsque le courant circule.

3. Procédé de détection de niveau de dégradation de batterie selon la revendication 1 ou 2, dans lequel le courant et la température de conduction de la batterie lorsque le courant circule sont mesurés, des facteurs de pondération correspondant au courant et à la température de conduction lorsque le courant circule sont pré-stockés dans la mémoire (7), en fonction des données stockées, des facteurs de pondération sont déterminés à partir du courant et de la température de conduction détectés lorsque le courant circule, et le niveau de dégradation de batterie est détecté à partir des facteurs de pondération déterminés.

4. Procédé de détection de niveau de dégradation de batterie selon l'une quelconque des revendications 1 à 3, dans lequel la limite de courant de batterie admissible est stockée dans la mémoire (7), et le temps accumulé pendant lequel la limite de courant est dépassée est détecté pour déterminer le niveau de dégradation de batterie.

5. Procédé de détection de niveau de dégradation de batterie selon l'une quelconque des revendications 1 à 4, dans lequel des limites de tension supérieure et inférieure de la batterie sont stockées dans la mémoire (7), et le temps accumulé pendant lequel les limites de tension supérieure et inférieure sont dépassées sont détectés afin de déterminer le niveau de dégradation de batterie.

6. Procédé de détection de niveau de dégradation de batterie selon l'une quelconque des revendications 1 à 5, dans lequel le temps accumulé dans la plage de température de stockage de chaque batterie est enregistré dans la mémoire (7) et le niveau de dégradation de batterie est détecté en fonction des données stockées.

7. Procédé de détection de niveau de dégradation de batterie selon l'une quelconque des revendications 1 à 6, dans lequel le temps accumulé dans la plage de température de conduction de chaque batterie lorsque le courant circule est enregistré dans la mémoire (7), et le niveau de dégradation de batterie est détecté en fonction des données stockées.

8. Procédé de détection de niveau de dégradation de batterie selon l'une quelconque des revendications 1 à 7, dans lequel le temps accumulé dans chaque plage de ∆SOC est enregistré dans la mémoire (7), et le niveau de dégradation de batterie est détecté en fonction des données stockées.

9. Procédé de détection de niveau de dégradation de batterie selon l'une quelconque des revendications 1 à 8, utilisé dans une application qui contrôle la charge et la décharge de la batterie au sein d'une plage de capacité résiduelle prédéfinie.

10. Procédé de détection de niveau de dégradation de batterie selon la revendication 9, utilisé dans une batterie (1) qui fournit de l'énergie à un moteur pour conduire un véhicule (10).

11. Procédé de détection de niveau de dégradation de batterie selon la revendication 9 appliqué à une batterie (1) utilisée dans une source d'alimentation qui stocke de l'énergie de cellule solaire.

# FIG. 1

# FIG. 2

EP 2 660 615 B1

FIG. 3

# FIG. 4

FIG. 5

EP 2 660 615 B1

# FIG. 6

# FIG. 7

# FIG. 8

# FIG. 9

SOH2(%)

INTERNAL RESISTANCE (mΩ)

# FIG. 10

```
                    ( START )
                        │
                        ▼
n=1      ┌──────────────────────────┐
         │ INITIALIZE SOH1, SOH2,   │
         │ AND SOH                  │
         └──────────────────────────┘
                        │
                        ▼ ◄─────────────────────┐
n=2      ┌──────────────────────────┐           │
         │ COMPUTE INTERNAL         │           │
         │ RESISTANCE               │           │
         └──────────────────────────┘           │
                        │                        │
                        ▼                        │
n=3      ┌──────────────────────────┐           │
         │ MEASURE CURRENT,         │           │
         │ TEMPERATURE, AND         │           │
         │ INTERNAL RESISTANCE      │           │
         └──────────────────────────┘           │
                        │                        │
                        ▼                     NO │
n=4      ◄── HAS 1SEC ELAPSED? ──────────────────┘
                        │
                        │ YES
                        ▼
n=5      ┌──────────────────────────┐
         │ COMPUTE I_rms,           │
         │ AVERAGE TEMPERATURE,     │
         │ AND INTERNAL RESISTANCE  │
         │ FOR THE 1SEC INTERVAL    │
         └──────────────────────────┘
                        │
                        ▼
n=6      ┌──────────────────────────┐
         │ COMPUTE SOH1 FROM I_rms  │
         │ AND AVERAGE TEMPERATURE  │
         │ IN THE 1SEC INTERVAL     │
         └──────────────────────────┘
                        │
                        ▼
n=7      ┌──────────────────────────┐
         │ COMPUTE SOH2 FROM THE    │
         │ INTERNAL RESISTANCE      │
         └──────────────────────────┘
                        │
                        ▼
n=8      ┌──────────────────────────┐
         │ DETERMINE THE FIRST      │
         │ WEIGHTING FACTOR AND     │
         │ SECOND WEIGHTING FACTOR  │
         └──────────────────────────┘
                        │
                        ▼
n=9      ┌──────────────────────────┐
         │ COMPUTE SOH FROM         │
         │ THE FIRST WEIGHTING FACTOR│
         │ AND SOH1 AND THE SECOND  │
         │ WEIGHTING FACTOR AND SOH2│
         └──────────────────────────┘
                        │
                        ▼
n=10     ┌──────────────────────────┐
         │ REVISE SOH1 ACCORDING    │
         │ TO THE COMPUTED SOH      │
         └──────────────────────────┘
                        │
                        ▼
                    ( END )
```

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- EP 1933158 A1
- US 2010001693 A1
- US 2006152196 A1
- JP 2008122165 A